# EUROPÄISCHE PATENTSCHRIFT

(11) **EP 4 043 899 B1**
(45) Veröffentlichungstag und Bekanntmachung des Hinweises auf die Patenterteilung: **02.10.2024**
(21) Anmeldenummer: 22150682.7
(22) Anmeldetag: 10.01.2022
(51) Int. Cl.: G01R 31/52, G01R 31/385

(54) **ANORDNUNG UND VERFAHREN ZUR AUTOMATISIERTEN DETEKTION EINER ELEKTRISCHEN GEFÄHRDUNG VOR MONTAGEARBEITEN AN HOCHVOLTBATTERIEN DES AKKUMULATOR-TYPS**
ARRANGEMENT AND METHOD FOR AUTOMATED DETECTION OF AN ELECTRICAL HAZARD BEFORE ASSEMBLY WORK ON HIGH POWER BATTERY OF THE ACCUMULATOR TYPE
DISPOSITIF ET PROCÉDÉ DE DÉTECTION AUTOMATISÉE D'UN DANGER ÉLECTRIQUE AVANT DES TRAVAUX DE MONTAGE DES BATTERIES À HAUTE TENSION DE TYPE ACCUMULATEUR

(30) Priorität: 11.02.2021 DE 102021201294
(43) Veröffentlichungstag der Anmeldung: 17.08.2022
(73) Patentinhaber: Volkswagen Aktiengesellschaft, 38440 Wolfsburg (DE)
(72) Erfinder: Richter, Stefan, 38531 Rötgesbüttel (DE); Balta, Dzana, 38112 Braunschweig (DE); Alimow, Alexander, 38118 Braunschweig (DE)

(56) Entgegenhaltungen:
- EP-B1- 3 532 855
- CN-A- 108 008 238
- DE-A1- 102013 013 950

## Beschreibung

Die Erfindung betrifft eine Anordnung zur automatisierten Detektion einer elektrischen Gefährdung an einer Hochvoltbatterie gemäß dem Oberbegriff des Anspruches 1 und ein Verfahren zur Gefährdungserkennung gemäß Anspruch 8.

Hochvoltbatterien des Akkumulator-Typs werden üblicherweise durch Zusammenbau mittels automatisierter Produktionslinien hergestellt und finden als Energiespeicher in vielen Bereichen der Technik verstärkt Anwendung. Insbesondere als wiederaufladbare Traktionsbatterien von Elektrofahrzeugen oder teilelektrisch betriebenen Hybridfahrzeugen haben sich Hochvoltbatterien der genannten Art als Energiespeicher durchgesetzt. Hochvoltbatterien dieses Typs bestehen üblicherweise aus einer Vielzahl von Batterie-Einzelzellen, wobei jede Einzelzelle eine Anode und eine Kathode aufweist, an denen die elektrochemischen Prozesse während des Ladens beziehungsweise Entladens stattfinden. Beide Elektroden weisen Kontakte auf, an die eine Spannung anlegbar ist (Laden) beziehungsweise an denen eine Spannung abgreifbar ist (Entladen). Um das Laden beziehungsweise Entladen zu bewirken ist ein Elektrolyt notwendig, der als lonenleiter dient und den Stromkreis zwischen Anode und Kathode schließt. Ein Separator verhindert einen direkten Kontakt zwischen den Elektroden und somit einen Kurzschluss. Bei dem Elektrolyten handelt es sich um eine Lösung eines Leitsalzes in einem Lösemittel oder um eine Ionische Flüssigkeit.

Traktionsbatterien des Zusammenbau-Typs bestehen wie erwähnt aus einer Vielzahl von Batterie-Einzelzellen. Diese sind jeweils durch eine Umhüllung gas- und flüssigkeitsdicht eingeschlossen, lediglich die Kontakte sind nach außen geführt. Die Umhüllung ist notwendig um die Einzelzellen gegeneinander zu separieren und, aufgrund der üblichen Verwendung von flüssigen oder pastösen Elektrolyten, ein Entweichen des Elektrolyten zu verhindern. Im Zusammenbau wird durch Reihenschaltung der vorstehend beispielhaft beschriebenen Batterie-Einzelzellen eine Hochvoltbatterie erzeugt, wobei die Einzelzellen mechanisch fixiert in einem umschließenden Gehäuse angeordnet sind. Das Gehäuse ist üblicherweise ebenfalls gas- und flüssigkeitsdicht ausgeführt und weist lediglich nach außen geführte elektrische Kontakte für das Laden bzw. Entladen und für Steuerungszwecke auf. Aus Stabilitätsgründen besteht das Gehäuse zumindest teilweise aus Metall und ist daher leitfähig.

Systembedingt weisen die Batterie-Einzelzellen bereits während des Montageprozesses eine Ladung auf, so dass während des weitgehend automatisierten Montageprozesses beim Zusammenbau der Hochvoltbatterien eine potentielle elektrische Gefährdung von Werkern eintreten kann, wenn diese an der Hochvoltbatterie oder in ihrem Umfeld Arbeiten ausführen. In diesem Zusammenhang ist insbesondere sicherzustellen, dass aufgrund von Montagefehlern oder fehlerhaften Bauteilen leitfähige Gehäuseteile, die im Normalfall keine elektrische Spannung führen, unter Spannung stehen. In einem solchen Fall können Werker, wenn diese an oder in der Nähe der Hochvoltbatterie hantieren, einer elektrischen Gefährdung ausgesetzt sein.

Eine elektrische Gefährdung bei Arbeiten an einem Hochvolt-System liegt vor, wenn eine Spannung zwischen den aktiven Teilen ab 60 Volt Gleichspannung (DC) oder 30 Volt Wechselspannung (AC) besteht und der Kurzschlussstrom an der Arbeitsstelle den Wert von 3 mA Wechselstrom (AC) oder 12 mA Gleichstrom (DC) übersteigt oder die Energie mehr als 350 mJ beträgt.

Da sich in der Praxis ein fehlerfreier Montageprozess nicht garantieren lässt, wurde bislang, um eine derartige Gefährdung auszuschließen, eine manuelle Messung zwischen den leitfähigen Gehäuseteilen der Hochvoltbatterie und dem Potenzial, das der Werker bei seinen Handhabungen annimmt oder annehmen kann durchgeführt. Eine derartige manuelle Messung ist jedoch zeitaufwändig und unzuverlässig, weil Fehler beim manuellen Messvorgang nicht ausgeschlossen werden können.

Aus der FR 2 858 799 ist eine Anordnung zum Handhaben einer konventionellen Fahrzeugbatterie bekannt, wobei die Anordnung dazu dient, die Batterie in einem Fahrzeug zu montieren. Um sicherzustellen, dass die Batterie eine für den Betrieb des Fahrzeugs ausreichende Mindestladung aufweist, ist in die Anordnung eine Messeinrichtung integriert, die zwei Messfühler aufweist. Die Messfühler sind dabei federnd ausgebildet und so angeordnet, dass diese beim Absenken der Handhabungsanordnung auf die Pole der Batterie drücken und so einen elektrischen Kontakt mit diesen herstellen. Die Messfühler sind Teil einer Messeinrichtung, die eine Messung der Batterieladung vornimmt. In Abhängigkeit vom Ergebnis der Messung erfolgt eine Signalgabe an den die Handhabungsanordnung bedienenden Werker, so dass dieser im Falle einer nicht ausreichenden Ladung den Montagevorgang abbrechen kann.

Der vorstehende Lösungsvorschlag ist für die Überwachung eines Montagevorgangs von Batterien in Fahrzeugen gedacht, um sicherzustellen das die montierten Batterien ausreichend geladen sind. Für die Sicherstellung der Spannungsfreiheit des Gehäuses einer Hochvoltbatterie während des Montageprozesses sind die Handhabungsanordnung bzw. das mit der Anwendung der Handhabungsanordnung gegebenen Messverfahren nicht geeignet.

Aus der CN 108 008 238 A sind eine Vorrichtung und ein Verfahren zur Prüfung der elektrischen Leckage einer Lithiumbatterie bekannt. Die EP 3 532 855 B1 offenbart eine gattungsgemäße Anordnung.

Die Aufgabe der der Erfindung besteht darin, eine Anordnung und ein Verfahren bereitzustellen, mit deren Hilfe eine elektrische Gefährdung insbesondere vor Montagearbeiten an Hochvoltbatterien des Akkumulator-Typs detektierbar ist.

Die Aufgabe ist durch die Merkmale des Anspruches 1 oder 8 gelöst. Bevorzugte Weiterbildungen der Erfindung sind in en Unteransprüchen offenbart.

Zum besseren Verständnis der nachfolgenden Ausführungen ist vorab darauf hinzuweisen, dass es sich bei der in Rede stehenden Anordnung um eine Anordnung aus mechanischen und elektronischen Komponenten handelt, wie sie beispielsweise in der Produktion oder im Service eingesetzt werden. Derartige Anordnungen beinhalten üblicherweise ein computergestütztes Steuersystem, das in Speichern gespeicherte Steuerungsanweisungen mittels Prozessoren verarbeitet. Insbesondere die nachfolgend angesprochene Steuereinrichtung und die von ihr ausgeführten Steuerungsabläufe sowie die Auswerteeinrichtung sind solche zu Befehlsroutinen zusammengefasste Steuerungsanweisungen, die - verarbeitet durch den oder die Prozessoren - die ihnen zugeordneten Steuerungsaufgaben mittels mit diesem in Wirkverbindung stehenden Eingabe- bzw. Ausgabemittel, Sensoren, Aktoren und Übertragungsmittel ausführen. Die nachfolgend angesprochene Steuereinrichtung, ebenso wie die Auswerteeinrichtung sind im Normalfall demnach keine abgrenzbaren Hardwareeinheiten, sondern existieren im Rahmen des computergestützten Steuersystems nur virtuell und temporär.

Für die Anordnung zur automatisierten Feststellung einer elektrischen Gefährdung, insbesondere vor Montagearbeiten an Hochvoltbatterien des Akkumulator-Typs, wird von einer Aushebeeinrichtung ausgegangen, mittels der eine Hochvoltbatterie, die wenigstens ein leitfähiges Gehäuseteil aufweist, aus einer Vorrichtung aushebbar und einer manuellen Montagestation zuführbar ist.

Erfindungsgemäß ist vorgeschlagen, dass die Aushebeeinrichtung wenigstens einen Messdorn aufweist, der mit einer Messeinrichtung verbunden ist und die Aushebeeinrichtung weiter bevorzugt so ausgebildet ist, dass der wenigstens eine Messdorn beim Ausheben der Hochvoltbatterie aus der Vorrichtung automatisch mit dem wenigstens einen leitfähigen Gehäuseteil in elektrische Verbindung gelangt. Weiter wird vorgeschlagen, eine Steuereinrichtung vorzusehen, die mit der Messeinrichtung und einer Auswerteeinrichtung wirkverbunden ist, wobei die Steuereinrichtung so ausgebildet ist, dass diese mittels der Messeinrichtung und dem mit dieser verbundenen wenigstens einen Messdorn in wenigsten einem Messvorgang wenigstens eine Potenzialdifferenz zwischen dem wenigstens einen Gehäuseteil und wenigstens einem Potenzial, das ein Werker während der Montagearbeiten annimmt oder annehmen kann, direkt oder indirekt ermittelt und mittels der Auswerteeinrichtung mit vorgegebenen Werten vergleicht. Weiter ist vorgesehen, dass die Steuereinrichtung eine Wirkverbindung mit wenigstens einer peripheren Einrichtung aufweist und so ausgebildet ist, dass sie im Falle des Überschreitens der vorgegebenen Werte ein Betreten eines durch eine potenzielle elektrische Gefährdung gegebenen Gefahrenbereichs durch entsprechendes Ansteuern der wenigstens einen peripheren Einrichtung sperrt und im Falle des Unterschreitens der vorgegebenen Werte ein Betreten des durch die potenzielle elektrische Gefährdung gegebenen Gefahrenbereichs durch entsprechendes Ansteuern der peripheren Einrichtungen freigibt.

Mit der erfindungsgemäßen Anordnung wird vorteilhaft erreicht, dass automatisch, bevor ein Werker einen potentiell durch eine elektrische Gefährdung gegebenen Gefahrenbereich betreten kann, sichergestellt ist, dass keine elektrische Gefährdung vorliegt. Bei Vorliegen einer elektrischen Gefährdung kann der Werker am Betreten des Gefahrenbereichs gehindert werden.

In Weiterbildung der Anordnung ist vorgesehen, dass die Aushebeeinrichtung eine Mehrzahl von Messdornen aufweist, die beim Ausheben automatisch mit dem wenigstens einen leitfähigen Gehäuseteil in elektrische Verbindung gelangen, wobei die Mehrzahl von Messdornen dazu dient, mittels einer Mehrzahl von unabhängigen Messvorgängen Potenzialdifferenzen oder zu diesen äquivalente Messwerte zu ermitteln. Mit dieser Maßnahme wird vorteilhaft erreicht, dass einerseits durch Mehrfachmessung das Messergebnis abgesichert werden kann. Andererseits wird für den Fall, dass unterschiedliche Gehäuseteile, die zum Beispiel durch Montagefehler galvanisch getrennt sind und so unterschiedliche Potenziale annehmen können, durch die Mehrzahl von Messvorgängen vorteilhaft mit erfasst werden. In einem solchen Fall würden auch Messvorgänge zwischen jeweils zwei Messdornen durchgeführt werden, um die Detektion einer elektrischen Gefährdung durch eine Potenzialdifferenz zwischen zwei galvanisch getrennten Gehäuseteilen in vorteilhafter Weise sicher auszuschließen.

In weiterer vorteilhafter Ausgestaltung der erfindungsgemäßen Anordnung kann die Steuereinrichtung so ausgebildet sein, dass diese zur Überprüfung der Messeinrichtung vor und/oder nach dem eigentlichen Messvorgang einen Prüf-Messvorgang veranlasst, dessen Ergebnis für die korrekt funktionierende Messvorrichtung in Form eines zulässigen Wertebereichs hinterlegt ist. Auch in diesem Fall veranlasst die Steuereinrichtung mittels der Auswerteeinrichtung einen Vergleich des Messergebnisses mit dem zulässigen Wertebereich und verhindert im Falle des nicht Übereinstimmens des gemessenen Wertes mit einem Wert des zulässigen Wertebereichs unter Zuhilfenahme der Steuereinrichtung ein Betreten des durch die elektrische Gefährdung gegebenen Gefahrenbereichs. Hat zu diesem Zeitpunkt die Messung zur Ermittlung einer Potenzialdifferenz bereits stattgefunden verwirft die Steuereinrichtung diese hat die Ermittlung nicht stattgefunden führt die Steuereinrichtung diese nicht durch.

Eine bevorzugte Ausführungsform sieht vorteilhaft vor, dass der wenigstens eine Messdorn eine gegen die Messstelle federbeaufschlagte Messspitze aufweist. Ein derartiger Messdorn kann in vorteilhafter Weise so ausgebildet sein, dass die Messspitze in einer Linearführung geführt ist, wobei die Linearführung in einem Gehäuse gehalten ist und die Messspitze durch Zwischenlage einer Isolierung gegen die Gehäuseaußenseite elektrisch isoliert ist und mit ihrer Spitze aus dem Gehäuse herausragt. Bei einem so ausgebildeten Messdorn ist vorgesehen, dass die Messspitze an ihrem der Spitze abgewandten Ende mit einer Messleitung verbunden ist, die ihrerseits aus dem Gehäuse herausgeführt ist.

Um ein sicheres Anliegen der Messspitze an der Messstelle zu garantieren ist es von Vorteil, dass die Messspitze mittels einer Feder in Richtung auf ihre aus dem Gehäuse herausragende Spitze gegenüber dem Gehäuse vorgespannt ist und das Gehäuse eine erste Anlage aufweist, an der die unter Federwirkung stehende Messspitze im Ruhezustand mittels einer an ihr angeordneten zweiten Anlage anliegt.

Für den Einsatz der erfindungsgemäßen Anordnung ist ein Verfahrensablauf vorgesehen, der vorteilhaft folgende Merkmale umfasst:
Beim Ausheben der Hochvoltbatterie aus der Vorrichtung veranlasst die Steuereinrichtung einen Messvorgang, derart, dass eine Messeinrichtung eine Potenzialdifferenz oder einen korrelierenden Messwert zwischen wenigstens einem an der Aushebeeinrichtung angeordneten und an wenigstens einem Gehäuseteil elektrisch leitend anliegendem Messdorn und dem Potenzial, das ein Werker während der Montagearbeiten annimmt oder annehmen kann, direkt oder indirekt ermittelt. Sodann vergleicht die Steuereinrichtung mittels der Auswerteeinrichtung die festgestellte Potenzialdifferenz oder den zu dieser äquivalenten Messwert mit vorgegebenen gespeicherten Werten. Im Falle des Überschreitens der vorgegebenen Werte unterbindet die Steuereinrichtung ein Betreten des durch die elektrische Gefährdung gegebenen Gefahrenbereichs durch entsprechendes Ansteuern einer peripheren Einrichtung zur optischen Signalgabe und/oder zur akustischen Signalgabe und/oder zur mechanischen Absperrung. Im Falle des Unterschreitens der vorgegebenen Werte ermöglicht die Steuereinrichtung ein Betreten des durch die elektrische Gefährdung gegebenen Gefahrenbereichs durch entsprechendes Ansteuern einer peripheren Einrichtung zur optischen Signalgabe und/oder zur akustischen Signalgabe und/oder zur mechanischen Absperrung.

Eine vorteilhafte Weiterbildung des Verfahrens kann vorsehen, das Verfahren zu erweitern um die Messeinrichtung vor und/oder nach dem eigentlichen Messvorgang einer Prüfung zu unterziehen. Hierzu führt die Steuereinrichtung zur Überprüfung der Messeinrichtung vor und/oder nach dem eigentlichen Messvorgang einen Prüf-Messvorgang durch. Hierzu kann vorteilhaft vorgesehen sein, dass die Steuereinrichtung die Messeinrichtung mit einem Prüfstromkreis verbindet und so einen Messwert ermittelt. Sodann führt die Steuereinrichtung mittels der Auswerteeinrichtung einen Vergleich des Messwertes mit einem vorgegebenen gespeicherten Wert oder Wertebereich durch, wobei der gespeicherte Wert oder Wertebereich eine korrekt funktionierende Messvorrichtung repräsentiert. Im Falle des nicht Übereinstimmens des Messergebnisses mit dem Wert oder einem Wert des Wertebereichs unterbindet die Steuereinrichtung ein Betreten des durch die potenzielle elektrische Gefährdung gegebenen Gefahrenbereichs durch Ansteuern einer peripheren Einrichtung zur optischen Signalgabe und/oder zur akustischen Signalgabe und/oder zur mechanischen Absperrung. Hat zu diesem Zeitpunkt die Messung zur Ermittlung einer Potenzialdifferenz bereits stattgefunden, verwirft die Steuereinrichtung dieses Messergebnis.

Im Rahmen des Verfahrens kann vorteilhaft vorgesehen sein, dass der Messvorgang aus einer Mehrzahl von Einzelmessungen besteht und die Einzelmessungen gesteuert durch die Steuereinrichtung nacheinander ausgeführt werden. In diesem Fall kann die Steuereinrichtung die Messeinrichtung vorteilhaft so steuern, dass jede Messung mit einem anderen Messdorn ausgeführt wird. Weiter können Messvorgänge zwischen den Messdornen vorgesehen sein, um Potenzialdifferenzen zwischen galvanisch getrennten Gehäuseteilen zu erfassen.

Weitere Ausgestaltungen und Vorteile der Erfindung werden nachfolgend anhand der Zeichnungen näher erläutert. Es zeigen:
- Fig. 1: eine Prinzipdarstellung einer Anordnung zur automatisierten Feststellung einer elektrischen Gefährdung an Hochvoltbatterien des Akkumulator-Typs, und
- Fig. 2: eine Prinzipdarstellung eines Verfahrensablaufs.

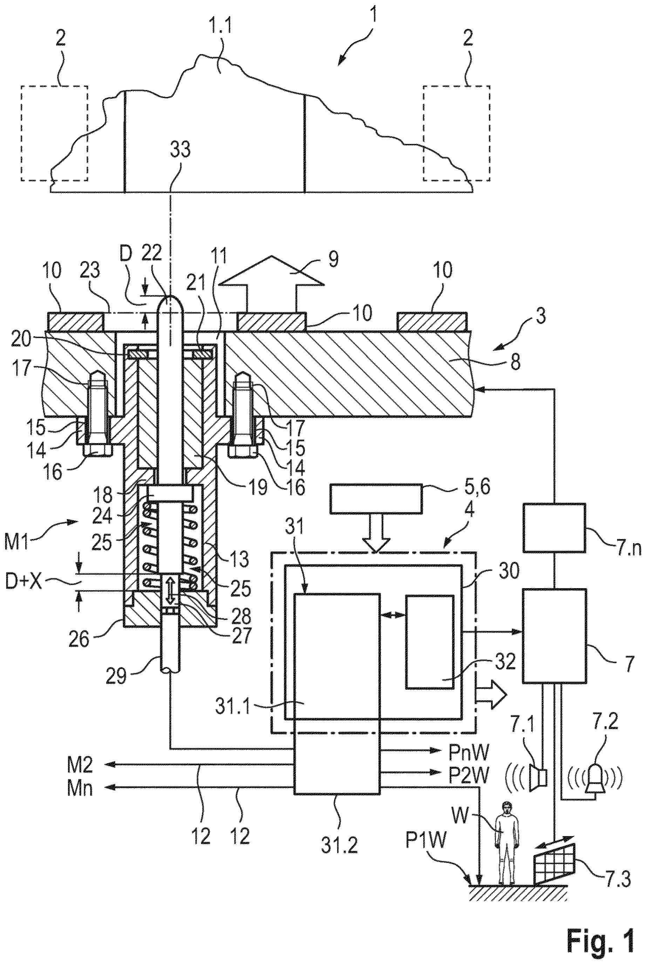

In der Darstellung gemäß Fig. 1 ist in vereinfachter Prinzipdarstellung ein Beispiel für eine Anordnung zur automatisierten Feststellung einer elektrischen Gefährdung an Hochvoltbatterien des Akkumulator-Typs dargestellt, die in eine Bandfertigungsanlage integriert ist und bei der eine zumindest zum Teil montierte Hochvoltbatterie 1 aus einer Vorrichtung 2 mittels einer Aushebevorrichtung 3 ausgehoben wird, um diese einer manuellen Bearbeitungsstation (nicht dargestellt) zuzuführen.

Die Bandfertigungsanlage, von der in Fig. 1 nur der hier relevante Teil dargestellt ist, wird durch ein computerbasiertes Steuersystem 4 gesteuert, das eine Steuereinrichtung 30 für unterschiedliche Steueraufgaben mittels in dem Steuersystem 4 vorgehaltener Befehlsroutinen virtuell und temporär ausbildet, indem diese Befehlsroutinen mittels eines oder mehrerer Prozessoren (nicht dargestellt) abgearbeitet werden und wobei Daten aus Eingabemitteln 5 und Sensoren 6 in die Abarbeitung einbezogen werden und wobei über Ausgabemittel 7 mittels Aktoren 7.n auf Teile der Bandfertigungsanlage und auf periphere Einrichtungen 7.1, 7.2, 7.3 eingewirkt wird. Da das Steuersystem 4 auch für andere als die hier betrachteten Aufgaben eingesetzt wird, ist dieses in der Darstellung mit strichpunktierter Linie gezeigt.

Gemäß der Darstellung in Fig. 1 ist eine Aushebevorrichtung 3 vorgesehen, die einen Aushebetisch 8 umfasst, der gesteuert durch das Steuersystem 4, mittels der Ausgabemittel 7 durch Ansteuerung von Aktoren 7.n, die auf den Aushebetisch 8 wirken, in Richtung auf die in der Vorrichtung 2 befindliche Hochvoltbatterie 1 angehoben wird, wie dies durch den Richtungspfeil 9 angedeutet ist. Die Ausgabemittel 7 sind in der Darstellung nur symbolhaft als Funktionsblock angedeutet, ihre konkrete Ausgestaltung ist hier nicht von Belang. An dem Aushebetisch 8 sind, der in der Vorrichtung 2 gehaltenen Hochvoltbatterie zugewandt, Ablagepuffer 10 angeordnet, die die Hochvoltbatterie 1 im abgelegten Zustand vor Beschädigungen schützen und gegebenenfalls gegen den Aushebetisch 8 isolieren. Weiter weist der Aushebetisch 8 eine Aussparung 11 auf, in der ein Messdorn M1 angeordnet ist. In gleicher Weise können noch weitere Messdorne M2 bis Mn an dem Aushebetisch 8 vorgesehen sein. Dies ist in der Darstellung nicht explizit gezeigt, sondern lediglich durch die gestrichelt eingezeichneten Messleitungen 12 angedeutet. Befestigung und Aufbau der weiteren Messdorne M2 bis Mn wäre identisch zum Messdorn M1, so dass sich eine nähere Beschreibung hierzu erübrigt.

Der in Fig. 1 gezeigte Messdorn M1 ist geschnitten dargestellt, ebenso der Aushebetisch 8. Die Schnittebene verläuft in Längsrichtung mittig durch den Messdorn M1. Wie aus der Darstellung ersichtlich, weist der Messdorn M1 ein Gehäuse 13 auf, das im Wesentlichen zylindrisch in Form einer Buchse aufgebaut ist und aus einem Isoliermaterial besteht. Am Umfang des Gehäuses 13 sind Befestigungsansätze 14 angeordnet, die Durchgangsbohrungen 15 aufweisen, über die das Gehäuse 13 mittels Schrauben 16 und in dem Aushebetisch 8 korrespondierend angeordneter Gewindelöcher 17 am Aushebetisch 8 festgelegt ist. Im Innern des Gehäuses 13 ist eine einen umlaufenden Balkon ausbildende Einschnürung 18 vorgesehen, die das Gehäuse 13 in zwei Hälften teilt.

In der in der Darstellung oberen Hälfte des Gehäuses 13 ist eine Führungsbuchse 19 im Wesentlichen spielfrei angeordnet und in axialer Richtung an der Einschnürung 18 abgestützt. An dem der Einschnürung 18 abgewandten Ende erfolgt die Fixierung der Führungsbuchse 19 in dem Gehäuse 13 mittels einer am Innenumfang des Gehäuses 13 angeordneter umlaufender Nut 20 und einem darin angeordneten Innensicherungsring 21, so dass die Führungsbuchse 19 in axialer Richtung festgelegt ist. In ihrer Längsrichtung ist die Führungsbuchse 19 von einer linear zu führenden leitfähigen Messspitze 22 mit geringem radialem Spiel durchsetzt, wobei die Messspitze 22 in Richtung auf die Oberkante 23 der Ablagepuffer 10 aus dem Gehäuse 13 heraus ragt und diese Oberkante 23 um eine Distanz D überragt.

Die Messspitze 22 ist weiter so ausgebildet, dass sie sich durch die Einschnürung 18 hindurch in den der Führungsbuchse 19 abgewandten Teil des Gehäuses 13 erstreckt. Auf dem Umfang der Messspitze 22 ist ein als umlaufender Balkon ausgebildeter Anschlag 24 angeordnet, der in Ruhestellung mit seiner der Einschnürung 18 zugewandten Seite kraftbeaufschlagt an der Einschnürung 18 anliegt. Die Kraftbeaufschlagung erfolgt durch eine vorgespannte Spiraldruckfeder 25, die auf der anderen Seite des Anschlags 24 angreift. Die Spiraldruckfeder 25 ist mit ihrer Spirale die Messspitze 22 umschließend auf dieser angeordnet, und liegt am Anschlag 24 an. An ihrem dem Anschlag 24 abgewandten Ende reicht die Spiraldruckfeder 25 um eine Wegstrecke D+X über das dem Anschlag 24 abgewandte Ende der Messspitze 22 hinaus und ist gegen einen Schraubverschluss 26 abgestützt, der das Gehäuse 13 zu dem Ende abschließt, das dem Aushebetisch 8 abgewandt ist.

Die Wegstrecke D+X steht dabei für den Weg, den die Messspitze 22 maximal einfedern kann, wenn von ihrem dem Messtisch 8 überragenden Ende her ein axial gerichteter Druck auf diese ausgeübt wird. Die Wegstrecke D ist dabei der im Normalbetrieb auftretende Federweg, bei der Wegstrecke X handelt es sich um eine Sicherheitsreserve. In dem Schraubverschluss 26 ist eine Messleitung 29 befestigt, die mit einem in dem Schraubverschluss 26 angeordneten Kontaktfederelement 27 elektrisch leitend verbunden ist. Das Kontaktfederelement 27 stellt den elektrischen Kontakt zu Messspitze 22 her und ist in der Lage, wie durch den Bewegungspfeil 28 angedeutet, um einen Federweg einzufedern, der dem freien Weg D+X der Messspitze 22 entspricht.

Abweichend zum dargestellten Beispiel besteht natürlich die Möglichkeit die Spiraldruckfeder 25 selbst als Kontaktfederelement auszubilden, so dass das im Beispiel gezeigte Kontaktfederelement 27 entfallen kann. Weiter besteht die Möglichkeit das Kontaktfederelement als lose, bewegliche Leitungsreserve der Messleitung 29 auszubilden und diese direkt mit der Messspitze 22 elektrisch leitend zu verbinden.

Die Messleitung 29 ist zu einer Messeinrichtung 31 geführt, die steuerungsseitige Teile 31.1 und apparative Teile 31.2 beinhaltet, wobei es sich bei den letztgenannten um den beziehungsweise die eigentlichen Messkreise handelt. In Fig. 1 sind die als Hardware realisierten apparativen Teile 31.2 als außerhalb der Steuereinrichtung 30 und außerhalb des Steuersystems 4 liegend dargestellt um diesen Umstand kenntlich zu machen. Die steuerungsseitigen Teile 31.1 der Messeinrichtung 31 sind Teil der Steuereinrichtung 30 die im oben beschriebenen Sinn virtuell und temporär vom Steuersystem 4 ausgebildet wird. Die Steuereinrichtung 30 beinhaltet eine virtuell und temporär ausgebildete Auswerteeinrichtung 32.

Wie oben ausgeführt, soll bereits während des Aushebevorganges, also bevor ein Werker W Zugang zur Hochvoltbatterie 1 hat, festgestellt werden, ob eine elektrische Gefährdung für den Werker W vorliegt, wenn dieser an der Hochvoltbatterie 1 arbeiten würde. Hierzu wird der Aushebetisch 8 durch entsprechende Ansteuerung der Ausgabemittel 7 und der mit diesen wirkverbundenen Aktoren 7.n in Richtung des Richtungspfeils 9 an die in der Vorrichtung 2 gehaltene Hochvoltbatterie 1 herangefahren, so dass einerseits die Messspitze 22 an der Messstelle 33 in Kontakt mit dem Gehäuse der Hochvoltbatterie 1 gelangt und gegen die Kraft der Spiraldruckfeder 25 in das Gehäuse 13 des Messdorns M1 hineingeschoben wird. Die Messspitze 22 liegt also unter der Kraft der Spiraldruckfeder 25 an der dem leitfähigen Gehäuseteil 1.1 zugeordneten Messstelle 33 an, wenn die Hochvoltbatterie 1 auf den Auflagepuffern 10 zu liegen kommt. Sodann werden Halteeinrichtungen (nicht dargestellt) der Vorrichtung 2 gelöst, so dass kein Kontakt mehr zwischen Vorrichtung 2 und Hochvoltbatterie 1 besteht. Der Aushebetisch 8 kann nun in eine andere Position gebracht werden. Nach dem Lösen der Hochvoltbatterie 1 aus der Vorrichtung 2 wird geprüft, ob eine potentielle Gefahr von der Hochvoltbatterie 1 ausgeht. Hierzu veranlasst die Steuereinrichtung 30 beim Ausheben der Hochvoltbatterie 1 aus der Vorrichtung 2 einen Messvorgang, derart dass die Messeinrichtung 31 eine Potenzialdifferenz oder einen korrelierenden Messwert zwischen der an der Aushebeeinrichtung 8 angeordneten, an dem wenigstens einen leitfähigen Gehäuseteil 1.1 elektrisch leitend anliegenden Messspitze 22 des Messdorns M1 und einem Potenzial P1W direkt oder indirekt ermittelt. Das Potenzial P1W ist dabei das Potenzial, das ein Werker W während der Montagearbeiten annimmt oder annehmen kann. Hierzu vergleicht die Steuereinrichtung 30 mittels der Auswerteeinrichtung 32 eine festgestellte Potenzialdifferenz zwischen der Messspitze 22 und dem Potenzial P1W oder einen korrelierenden Messwert mit vorgegebenen gespeicherten Werten.

Für den Fall, dass der gemessene Wert den gespeicherten, vorgegebenen Wert übersteigt, steuert die Steuereinrichtung 30 die Ausgabemittel 7 an, derart dass diese auf periphere Einrichtungen 7.1, 7.2, 7.3 wirken. Bei diesen peripheren Einrichtungen 7.1, 7.2, 7.3 handelt es sich um eine akustische Alarmeinrichtung 7.1, eine optische Alarmeinrichtung 7.2 und eine mechanische Absperrung 7.3, so dass durch akustische Signalgabe, zum Beispiel in Form eines Warntons, durch optische Signalgabe, zum Beispiel in Form eines Lichtsignals und durch geschlossen halten der mechanischen Absperrung 7.3 ein Betreten des durch die elektrische Gefährdung gegebenen Gefahrenbereichs verhindert wird. Für den Fall, dass der gemessene Wert unter dem gespeicherten, vorgegebenen Wert liegt, unterbleibt eine Ansteuerung der peripheren Einrichtungen 7.1, 7.2, 7.3 und das Steuersystem 4 gibt dann, wenn die Aushebeeinrichtung ihre endgültige Position erreicht hat, durch entsprechendes Ansteuern der mechanischen Absperrung 7.3 den Zugang zu der Hochvoltbatterie durch den Werker W frei.

Wie oben bereits angedeutet, können mehrere Messdorne M1, M2, Mn vorgesehen sein, zum Beispiel wenn mehrere leitfähige Gehäusebereiche vorliegen können, die durch fehlerhafte Montage nicht leitend verbunden sind. In einem solchen Fall ermittelt die Steuereinrichtung 30 die Potentialdifferenz zwischen allen Messdornen M1, M2, Mn untereinander und zwischen allen Messdornen M1, M2, Mn und dem Potenzial P1W das ein Werker W annimmt, oder annehmen kann und vergleicht diese mit gespeicherten Werten. Beim Überschreiten beziehungsweise Unterschreiten der gespeicherten Werte durch die gemessenen Werte wird so verfahren, wie vorstehend ausführlich beschrieben. Um Wiederholungen zu vermeiden wird auf den vorstehenden Absatz verwiesen. Kann der Werker W mehrere unterschiedliche Potenziale annehmen, wie dies in Fig. 1 durch die Potenziale P1W, P2W, PnW angedeutet ist, ist die vorstehend beschriebene Prozedur für alle Potenziale P1W, P2W, PnW durchzuführen. Auch hierzu wird, um Wiederholungen zu vermeiden, auf die vorstehenden Ausführungen verwiesen.

Zur Erhöhung der Sicherheit der Anordnung zur automatisierten Feststellung einer elektrischen Gefährdung vor Montagearbeiten an Hochvoltbatterien kann vorgesehen sein, vor der Feststellung einer Potenzialdifferenz eine Prüfmessung vorzusehen. Hierzu ist die Auswerteeinrichtung 32 so ausgebildet, dass das Ergebnis für die korrekt funktionierende Messeinrichtung 31 in der Auswerteeinrichtung 32 in Form eines zulässigen Wertebereichs hinterlegt ist und die Auswerteeinrichtung 32 das Messergebnis mit dem zulässigen Wertebereich vergleicht. Die Steuereinrichtung 30 ist ihrerseits so ausgebildet, dass sie im Falle des nicht Übereinstimmens des gemessenen Wertes mit einem Wert des Wertebereichs ein Betreten des durch die potenzielle elektrische Gefährdung gegebenen Gefahrenbereichs durch entsprechendes Ansteuern der Ausgabemittel 7 und über diese der peripheren Einrichtungen 7.1, 7.2, 7.3, sperrt und die Messung zur Ermittlung einer Potenzialdifferenz nicht durchführt.

Es besteht natürlich auch die Möglichkeit, die Prüfmessung der Ermittlung der Potenzialdifferenz nachzulagern. Wenn eine Potenzialdifferenz also bereits ermittelt wurde und die Prüfmessung nachgelagert ist, wird die Steuereinrichtung die ermittelte Potenzialdifferenz verwerfen.

Der Ablauf der Prüfmessung kann vielgestaltig ausgebildet sein, im einfachsten Fall wird der elektrische Widerstand zwischen zwei Messdornen zum Beispiel Messdorn M1 und Messdorn M2 ermittelt, wenn beide am selben leitfähigen Gehäuseteil 1.1 anliegen, so dass dieses die Messdorne M1, M2 kurzschließt. Wird ein Kurzschluss zwischen Messdorn M1 und Messdorn M2 gemessen, ist die Messanordnung in Ordnung, wird ein vom Kurzschluss abweichender Widerstandswert ermittelt, ist die Messanordnung nicht in Ordnung. Selbstverständlich besteht die Möglichkeit, auch komplexere Prüfmessungen vorzusehen. Entsprechende Vorgehensweisen sind dem Messtechniker bekannt, so dass sich explizite Ausführungen hierzu erübrigen.

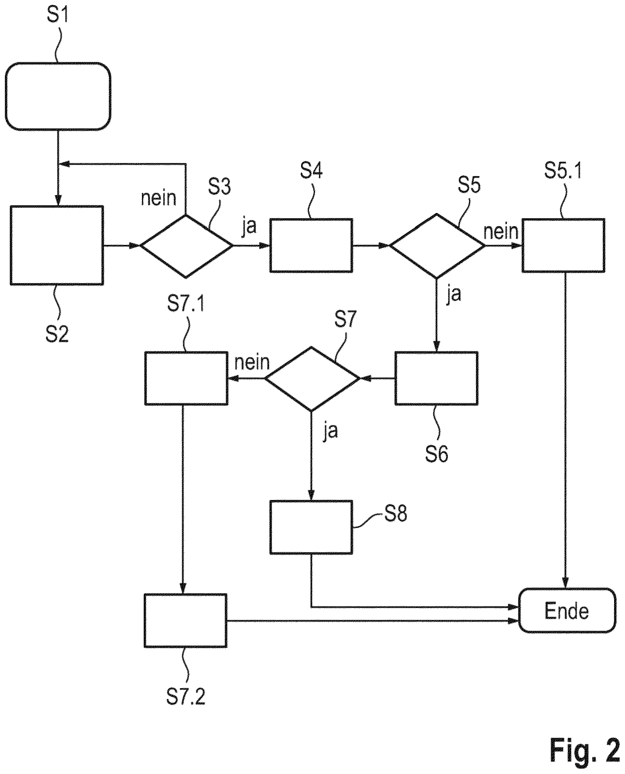

Zur Verdeutlichung der verfahrenstechnischen Vorgehensweise ist in Fig. 2 eine Prinzipdarstellung für einen beispielhaften Verfahrensablauf in Form eines Flussdiagramms gezeigt. Es wird nachfolgend auf die im hier betrachteten Zusammenhang ablaufenden Verfahrensschritte eingegangen, vorgelagerte Verfahrensschritte und nachgelagerte Verfahrensschritte bleiben unberücksichtigt. Die einzelnen Verfahrensschritte sind mit dem Buchstaben "S" und einer folgenden Nummerierung bezeichnet. Es ist hier unterstellt, dass zwei Messdorne, nämlich Messdorn M1 (Fig. 1) und ein identisch aufgebauter Messdorn M2 (in Fig. 1 nur mit der Bezeichnung M2) angedeutet zum Einsatz kommen. Da es sich um identisch aufgebaute Messdorne M1, M2 handelt, erhalten beide Messdorne M1, M2 nachfolgend für identische Bauteile identische Bezugszeichen. Weiter ist vorausgesetzt, dass die Messspitzen 22 der Messdorne M1, M2 beim Ausheben der Hochvoltbatterie 1 (Fig. 1) an demselben elektrisch leitfähigen Gehäuseteil 1.1 an jeweils ihnen zugeordneten Messstellen 33 zur Anlage kommen sollen. Im Nachfolgenden wird durch Benutzung der entsprechenden Begriffe und Bezugszeichen auf Fig. 1 und die zugehörige Beschreibung Bezug genommen, ohne dass dies eigens erwähnt ist.

### Verfahrensschritte:

| | |
|---|---|
| S1: | Das Steuersystem 4 prüft, ob die Vorrichtung 2 mit der Hochvoltbatterie 1 in der richtigen Position über der Aushebevorrichtung 3 ist. Dies kann mittels mechanischer Endschalter oder nach einem anderen physikalischen Prinzip arbeitender Positionskontrollmittel, wie zum Beispiel optischer Positionskontrollmittel geschehen. Derartige Positionskontrollmittel sind bekannt, so dass sich nähere Ausführungen hierzu erübrigen. Ist die richtige Position erreicht, wird mit Verfahrensschritt S2 fortgefahren. |
| S2: | Das Steuersystem 4 fährt durch Ansteuerung entsprechender Aktoren 7.n den Aushebetisch 8 an die Hochvoltbatterie 1 heran. |
| S3: | Das Steuersystem 4 kontrolliert das Erreichen der Endposition zum Beispiel durch zyklisches Abfragen einer Endposition-Kontrolleinrichtung, zum Beispiel eines Endschalters. Ist die Endposition nicht erreicht, fährt das Steuersystem 4 mit Schritt S2 fort, ist die Endposition erreicht, fährt das Steuersystem 4 mit Schritt S4 fort. |
| S4: | Ist die Endposition erreicht liegen die Messspitzen 22 der beiden Messdorne M1 und M2 an den ihnen zugeordneten Messstellen 33 an, die wie vorstehend erwähnt auf demselben leitfähigen Gehäuseteil 1.1 liegen. Das Steuersystem 4 führt nun eine Prüfmessung durch um festzustellen, ob die Messanordnung in ihrer Gesamtheit in Ordnung ist. Hierzu initiiert das Steuersystem 4 das Anlegen einer Messspannung an die Messspitzen 22 der Messdorne M1, M2 und veranlasst eine Widerstandsmessung. |
| S5: | Das Steuersystem 4 vergleicht den gemessenen Wert mit einem im Steuersystem 4 vordefinierten Wertebereich. Liegt der Widerstand innerhalb des vorgegebenen Wertebereichs fährt das Steuersystem 4 mit Verfahrensschritt S6 fort. Liegt der Widerstand nicht innerhalb des vorgegebenen Bereichs initiiert das Steuersystem 4 einen ersten Alarmmodus S5.1. |
| S5.1: | Das Steuersystem 4 visualisiert gegenüber einem Mitarbeiter, zum Beispiel durch akustisch und/oder optisch und oder haptisch wahrnehmbare Signalgabe, dass ein Defekt vorliegt und beendet den Steuerablauf. |
| S6: | Das Steuersystem 4 initiiert einen Messvorgang dergestalt, dass eine Spannungsmessung zwischen jeweils einem Messdorn M1, M2 und einem Potenzial P1W erfolgt, das der Werker W einnimmt oder einnehmen kann. |
| S7: | Das Steuersystem 4 vergleicht den gemessenen Wert mit einem im Steuersystem 4 vordefinierten Wertebereich. Liegt der Spannungswert innerhalb des vorgegebenen Wertebereichs fährt das Steuersystem 4 mit Verfahrensschritt S8 fort. Liegt der Spannungswert nicht innerhalb des vorgegebenen Bereichs initiiert das Steuersystem 4 einen zweiten Alarmmodus S7.1. |
| S7.1: | Das Steuersystem 4 visualisiert gegenüber einem Mitarbeiter, zum Beispiel durch akustisch und/oder optisch und oder haptisch wahrnehmbare Signalgabe, dass ein Defekt vorliegt. |
| S7.2: | Das Steuersystem 4 leitet Maßnahmen zum Nacharbeiten der Hochvoltbatterie ein und beendet den Steuerablauf. |
| S8: | Das Steuersystem 4 gibt durch Entriegeln der mechanischen Absperrung 7.3 den Zugang zur Hochvoltbatterie frei und beendet den Steuerablauf. |

Wie bereits einleitend ausgeführt, kann die vorstehend beschriebene Anordnung sowie das vorstehend beschriebene Verfahren nicht nur in der Produktion, sondern auch im Servicebereich eingesetzt werden. In diesem Fall ist die Anordnung zur automatisierten Feststellung einer elektrischen Gefährdung nicht in eine Produktionsanlage integriert, sondern eigenständig. Am Aufbau und der verfahrenstechnischen Vorgehensweise ändert sich ansonsten nichts. Eine Anwendung im Service ist im Zusammenhang mit dem Entnehmen einer Hochvoltbatterie aus einem Fahrzeug besonders vorteilhaft.

### Bezugszeichenliste

- 1: Hochvoltbatterie
- 2: leitfähiges Gehäuseteil
- 3: Aushebevorrichtung
- 4: Steuersystem
- 5: Eingabemittel
- 6: Sensoren
- 7: Ausgabemittel
- 7.1: akustische Alarmeinrichtung
- 7.2: optische Alarmeinrichtung
- 7.3: mechanische Absperrung
- 7.n: Aktoren
- 8: Aushebetisch
- 9: Richtungspfeil
- 10: Ablagepuffer
- 11: Aussparung
- 12: Messleitungen
- 13: Gehäuse (des Messdorns M1)
- 14: Befestigungsansätze
- 15: Durchgangsbohrung
- 16: Schrauben
- 17: Gewindelöcher
- 18: Einschnürung
- 19: Führungsbuchse
- 20: umlaufende Nut
- 21: Innensicherungsring
- 22: Messspitze
- 23: Oberkante (der Ablagepuffer 10)
- 24: Anschlag
- 25: Spiraldruckfeder
- 26: Schraubverschluss
- 27: Kontaktfederelement
- 28: Bewegungspfeil
- 29: Messleitung
- 30: Steuereinrichtung
- 31: Messeinrichtung
- 31.1: steuerungsseitiger Teil (der Messeinrichtung 31)
- 31.2: apparativer Teil (der Messeinrichtung 31)
- 32: Auswerteeinrichtung
- 33: Messstelle
- M1, M2, Mn: Messdorn
- P1W, P2W, PnW: Potenzial (das ein Werker W einnehmen kann)
- W: Werker
- S1 bis S8: Steuerschritt

## Patentansprüche

1. Anordnung zur automatisierten Detektion einer elektrischen Gefährdung vor Durchführung von Montagearbeiten an einer Hochvoltbatterie, wobei die Hochvoltbatterie (1) wenigstens ein leitfähiges Batteriegehäuseteil (1.1) aufweist und mittels einer Aushebeeinrichtung (3) aus einer Vorrichtung (2) hebbar und einer manuellen Montagestation zuführbar ist, dass der Anordnung eine Messeinrichtung (31) zugeordnet ist, mittels der eine Potenzialdifferenz zwischen dem Batteriegehäuseteils (1.1) und einem Potenzial (P1W, P2W, PnW), das ein Werker (W) während der Montagearbeiten annimmt, ermittelbar ist, **dadurch gekennzeichnet, dass** die Messeinrichtung (3) wenigstens einen Messdorn (M1, M2, Mn) aufweist, der Bestandteil der Aushebeeinrichtung (3) ist, und dass der Messdorn (M1, M2, Mn) mit der Messeinrichtung (31) wirkverbunden ist.

2. Anordnung nach Anspruch 1, **dadurch gekennzeichnet, dass**
- die Aushebeeinrichtung (3) so ausgebildet ist, dass der Messdorn (M1, M2, Mn) beim Heben der Hochvoltbatterie (1) aus der Vorrichtung (2) automatisch mit dem Batteriegehäuseteil (1.1) in elektrische Verbindung gelangt,
- eine Steuereinrichtung (30) vorgesehen ist, die mit der Messeinrichtung (31) und einer Auswerteeinrichtung (32) wirkverbunden ist,
- die Steuereinrichtung (30) so ausgebildet ist, dass diese mittels der Messeinrichtung (31) und dem Messdorn (M1, M2, Mn) in einem Messvorgang die Potenzialdifferenz zwischen dem Batteriegehäuseteil (1.1) und dem Potenzial (P1W, P2W, PnW), das der Werker (W) während der Montagearbeiten annimmt, direkt oder indirekt ermittelt und mittels der Auswerteeinrichtung (32) dieses mit vorgegebenen Werten vergleicht,
- die Steuereinrichtung (30) mit wenigstens einer peripheren Einrichtung (7.1, 7.2, 7.3) wirkverbunden und so ausgebildet ist, dass sie im Falle des Überschreitens der vorgegebenen Werte ein Betreten eines durch eine potenzielle elektrische Gefährdung gegebenen Gefahrenbereichs durch entsprechendes Ansteuern der wenigstens einen peripheren Einrichtung (7.1, 7.2, 7.3) sperrt, und im Falle des Unterschreitens der vorgegebenen Werte ein Betreten des durch die potenzielle elektrische Gefährdung gegebenen Gefahrenbereichs durch entsprechendes Ansteuern der peripheren Einrichtungen (7.1, 7.2, 7.3) freigibt.

3. Anordnung nach Anspruch 2, **dadurch gekennzeichnet, dass** die Aushebeeinrichtung (3) eine Mehrzahl von Messdornen (M1, M2, Mn) aufweist, die beim Hebe-Vorgang automatisch mit dem wenigstens einen leitfähigen Gehäuseteil (1.1) in elektrische Verbindung gelangen, und dass die Mehrzahl von Messdornen (M1, M2, Mn) dazu dient, mittels einer Mehrzahl von unabhängigen Messvorgängen Potenzialdifferenzen zu ermitteln.

4. Anordnung nach einem der Ansprüche 2 oder 3, **dadurch gekennzeichnet, dass**
- die Steuereinrichtung (30) so ausgebildet ist, dass diese zur Überprüfung der Messeinrichtung (31) vor und/oder nach dem eigentlichen Messvorgang einen Prüf-Messvorgang veranlasst,
- die Auswerteeinrichtung (32) so ausgebildet ist, dass das Ergebnis für die korrekt funktionierende Messeinrichtung (31) in dieser in Form eines zulässigen Wertebereichs hinterlegt ist und die Auswerteeinrichtung (32) das Messergebnis mit dem zulässigen Wertebereich vergleicht,
- die Steuereinrichtung (30) so ausgebildet ist, dass sie bei Nichtübereinstimmung des gemessenen Wertes mit einem Wert des Wertebereichs ein Betreten des durch die potenzielle elektrische Gefährdung gegebenen Gefahrenbereichs durch entsprechendes Ansteuern der peripheren Einrichtung (7.1, 7.2, 7.3) sperrt und die Messung zur Ermittlung einer Potenzialdifferenz verwirft oder nicht durchführt.

5. Anordnung nach einem der Ansprüche 2 bis 4, **dadurch gekennzeichnet, dass** der Messdorn (M1, M2, Mn) eine gegen die Messstelle (33) federbeaufschlagte Messspitze (22) aufweist, und/oder dass die Messspitze (22) in einer Linearführung geführt ist, wobei die Linearführung in einem Gehäuse (13) gehalten ist und die Messspitze (22) durch Zwischenlage einer Isolierung gegen die Gehäuseaußenseite elektrisch isoliert ist, mit ihrer Spitze aus dem Gehäuse (13) herausragt und an ihrem der Spitze abgewandten Ende mit einer Messleitung (29) verbunden ist, die ihrerseits aus dem Gehäuse (13) herausgeführt ist.

6. Anordnung nach Anspruch 5, **dadurch gekennzeichnet, dass** die Messspitze (22) mittels einer Feder in Richtung auf ihre aus dem Gehäuse (13) herausragenden Spitze gegenüber dem Gehäuse (13) vorgespannt ist und das Gehäuse (13) eine erste Anlage aufweist, an der die unter Federwirkung stehende Messspitze (22) im Ruhezustand mittels einer an ihr angeordneten zweiten Anlage anliegt.

7. Anordnung nach einem der vorhergehenden Ansprüche, **dadurch gekennzeichnet, dass** die wenigstens eine periphere Einrichtung (7.1, 7.2, 7.3) eine Einrichtung zur akustischen Signalgabe und/oder zur optischen Signalgabe und/oder zur Freigabe oder Sperrung einer mechanischen Absperrung ist.

8. Verfahren zur automatisierten Detektion einer elektrischen Gefährdung vor Durchführung von Montagearbeiten an einer Hochvoltbatterie mittels einer Anordnung gemäß einem der vorstehenden Ansprüche, **dadurch gekennzeichnet, dass** mittels der Messeinrichtung (31) eine Potenzialdifferenz zwischen dem Batteriegehäuseteil (1.1) und einem Potenzial (P1W, P2W, PnW, das ein Werker (W) während der Montagearbeiten annimmt, ermittelt wird.

9. Verfahren nach Anspruch 8, **dadurch gekennzeichnet, dass**
- das die Steuereinrichtung (30) ausbildende Steuersystem (4) beim Heben der Hochvoltbatterie (1) aus der Vorrichtung (2) einen Messvorgang veranlasst, derart, dass die Messeinrichtung (31) eine Potenzialdifferenz oder einen korrelierenden Messwert zwischen der an dem Batteriegehäuseteil (1.1) elektrisch leitend anliegenden Messspitze (22) und dem Potenzial (P1W, P2W, PnW) ermittelt, das ein Werker (W) während der Montagearbeiten annimmt,
- die Steuereinrichtung (30) mittels der Auswerteeinrichtung (32) eine festgestellte Potenzialdifferenz oder einen korrelierenden Messwert mit vorgegebenen gespeicherten Werten vergleicht und im Falle des Überschreitens der vorgegebenen Werte ein Betreten des durch die elektrische Gefährdung gegebenen Gefahrenbereichs durch Ansteuern einer peripheren Einrichtung (7.1, 7.2, 7.3) zur akustischen Signalgabe und/oder zur optischen Signalgabe und/oder zur mechanischen Absperrung unterbindet, und im Falle des Unterschreitens der vorgegebenen Werte ein Betreten des durch die elektrische Gefährdung gegebenen Gefahrenbereichs durch Ansteuern einer peripheren Einrichtung (7.1, 7.2, 7.3) zur akustischen Signalgabe und/oder zur optischen Signalgabe und/oder zur mechanischen Absperrung ermöglicht.

10. Verfahren nach Anspruch 9, **dadurch gekennzeichnet, dass**
- die Steuereinrichtung (30) zur Überprüfung der Messeinrichtung (31) vor und/oder nach dem eigentlichen Messvorgang einen Prüf-Messvorgang veranlasst, dessen Ergebnis für die korrekt funktionierende Messeinrichtung (31) vorbekannt ist,
- die Steuereinrichtung (30) das Messergebnis mittels der Auswerteeinrichtung (32) mit einem vorgegebenen gespeicherten Wert oder Wertebereich vergleicht,
- die Steuereinrichtung (30) bei Nichtüberschreitung ein Betreten des durch die potenzielle elektrische Gefährdung gegebenen Gefahrenbereichs durch Ansteuern einer peripheren Einrichtung (7.1, 7.2, 7.3) zur optischen Signalgabe und/oder zur akustischen Signalgabe und/oder zur mechanischen Absperrung unterbindet und die Messung zur Ermittlung einer Potenzialdifferenz verwirft oder nicht durchführt.

## Claims

1. Arrangement for automated detection of an electrical hazard before carrying out assembly work on a high-voltage battery, wherein the high-voltage battery (1) comprises at least one conductive battery housing part (1.1) and can be lifted out of an apparatus (2) by means of a lifting device (3) and can be supplied to a manual assembly station, that the arrangement is associated with a measuring device (31), by means of which a potential difference between the battery housing part (1.1) and a potential (P1W, P2W, PnW) assumed by a worker (W) during assembly work can be determined, **characterized in that**
the measuring device (3) comprises at least one measuring mandrel (M1, M2, Mn) which is part of the lifting device (3), and **in that** the measuring mandrel (M1, M2, Mn) is operatively connected to the measuring device (31).

2. Arrangement according to claim 1, **characterized in that**
- the lifting device (3) is designed in such a way that the measuring mandrel (M1, M2, Mn) automatically comes into electrical connection with the battery housing part (1.1) when the high-voltage battery (1) is lifted out of the apparatus (2), and
- a control device (30) is provided which is operatively connected to the measuring device (31) and an evaluation device (32),
- the control device (30) is designed in such a way that, in a measuring process, it uses the measuring device (31) and the measuring mandrel (M1, M2, Mn) to directly or indirectly determine the potential difference between the battery housing part (1.1) and the potential (P1W, P2W, PnW) assumed by the worker (W) during assembly work, and compares this with predetermined values using the evaluation device (32),
- the control device (30) is operatively connected to at least one peripheral device (7.1, 7.2, 7.3) and is designed in such a way that if the predetermined values are exceeded, it blocks entry into a danger area caused by a potential electrical hazard by correspondingly controlling the at least one peripheral device (7.1, 7.2, 7.3), and if the predetermined values are not met, it allows entry into the danger area caused by the potential electrical hazard by correspondingly controlling the peripheral devices (7.1, 7.2, 7.3).

3. Arrangement according to claim 2, **characterized in that** the lifting device (3) comprises a plurality of measuring mandrels (M1, M2, Mn) which automatically come into electrical connection with the at least one conductive housing part (1.1) during the lifting process, and **in that** the plurality of measuring mandrels (M1, M2, Mn) are used to determine potential differences by means of a plurality of independent measuring processes.

4. Arrangement according to either claim 2 or claim 3, **characterized in that**
- the control device (30) is designed in such a way that it initiates a test measuring process to check the measuring device (31) before and/or after the actual measuring process,
- the evaluation device (32) is designed in such a way that the result for the correctly functioning measuring device (31) is stored therein in the form of a permissible value range and the evaluation device (32) compares the measurement result with the permissible value range,
- the control device (30) is designed in such a way that if the measured value does not match a value of the value range, it blocks entry into the danger area caused by the potential electrical hazard by correspondingly controlling the peripheral device (7.1, 7.2, 7.3), and rejects or does not carry out the measurement to determine a potential difference.

5. Arrangement according to any of claims 2 to 4, **characterized in that** the measuring mandrel (M1, M2, Mn) comprises a measuring tip (22) which is springloaded against the measuring point (33), and/or **in that** the measuring tip (22) is guided in a linear guide, wherein the linear guide is held in a housing (13) and the measuring tip (22) is electrically insulated from the outside of the housing by interposed insulation, protrudes with its tip from the housing (13) and is connected at its end facing away from the tip to a measuring line (29), which in turn leads out of the housing (13).

6. Arrangement according to claim 5, **characterized in that** the measuring tip (22) is preloaded against the housing (13) by means of a spring in the direction of its tip protruding from the housing (13), and the housing (13) comprises a first contact against which the spring-actuated measuring tip (22) rests in the resting state by means of a second contact arranged thereon.

7. Arrangement according to any of the preceding claims, **characterized in that** the at least one peripheral device (7.1, 7.2, 7.3) is a device for acoustic signaling and/or for optical signaling and/or for releasing or blocking a mechanical barrier.

8. Method for automated detection of an electrical hazard before carrying out assembly work on a high-voltage battery by means of an arrangement according to any of the preceding claims, **characterized in that**
a potential difference between the battery housing part (1.1) and a potential (P1W, P2W, PnW) assumed by a worker (W) during assembly work is determined by means of the measuring device (31).

9. Method according to claim 8, **characterized in that**
- the control system (4) forming the control device (30) initiates a measuring process when the high-voltage battery (1) is lifted out of the apparatus (2), in such a way that the measuring device (31) determines a potential difference or a correlating measured value between the measuring tip (22) electrically conductively applied to the battery housing part (1.1) and the potential (P1W, P2W, PnW) assumed by a worker (W) during assembly work,
- the control device (30) uses the evaluation device (32) to compare a detected potential difference or a correlating measured value with predetermined stored values and, if the predetermined values are exceeded, prevents entry into the danger area caused by the electrical hazard by controlling a peripheral device (7.1, 7.2, 7.3) for acoustic signaling and/or optical signaling and/or mechanical blocking, and, if the predetermined values are not met, allows entry into the danger area caused by the electrical hazard by controlling a peripheral device (7.1, 7.2, 7.3) for acoustic signaling and/or optical signaling and/or mechanical blocking.

10. Method according to claim 9, **characterized in that**
- the control device (30) initiates a test measuring process for checking the measuring device (31) before and/or after the actual measuring process, the result of which is known in advance for the correctly functioning measuring device (31),
- the control device (30) compares the measurement result with a predetermined stored value or value range by means of the evaluation device (32),
- the control device (30), if the limit is not exceeded, prevents entry into the danger area caused by the potential electrical hazard by controlling a peripheral device (7.1, 7.2, 7.3) for optical signaling and/or acoustic signaling and/or mechanical blocking and rejects or does not carry out the measurement for determining a potential difference.

## Revendications

1. Agencement pour la détection automatisée d'un danger électrique avant l'exécution de travaux de montage sur une batterie haute tension, dans lequel la batterie haute tension (1) présente au moins une partie de boîtier de batterie (1.1) conductrice et peut être soulevée d'un dispositif (2) à l'aide d'un appareil de levage (3) et amenée à un poste de montage manuel, en ce qu'un appareil de mesure (31) est associé à l'agencement, à l'aide duquel une différence de potentiel entre la partie de boîtier de batterie (1.1) et un potentiel (P1W, P2W, PnW), qu'un ouvrier (W) reçoit pendant les travaux de montage, peut être déterminée, **caractérisé en ce que**
l'appareil de mesure (3) présente au moins un mandrin de mesure (M1, M2, Mn) qui fait partie intégrante de l'appareil de levage (3), **et en ce que** le mandrin de mesure (M1, M2, Mn) est en liaison active avec l'appareil de mesure (31).

2. Agencement selon la revendication 1, **caractérisé en ce que**
- l'appareil de levage (3) est conçu de telle sorte que le mandrin de mesure (M1, M2, Mn) arrive automatiquement en liaison électrique avec la partie de boîtier de batterie (1.1) lors du levage de la batterie haute tension (1) hors du dispositif (2), il est prévu un appareil de commande (30) qui est en liaison active avec l'appareil de mesure (31) et un appareil d'évaluation (32),
- l'appareil de commande (30) est conçu de telle sorte qu'il détermine directement ou indirectement, à l'aide de l'appareil de mesure (31) et du mandrin de mesure (M1, M2, Mn), dans un processus de mesure, la différence de potentiel entre la partie de boîtier de batterie (1.1) et le potentiel (P1W, P2W, PnW) que l'ouvrier (W) reçoit pendant les travaux de montage et compare celle-ci à des valeurs prédéfinies à l'aide de l'appareil d'évaluation (32),
- l'appareil de commande (30) est en liaison active avec au moins un appareil périphérique (7.1, 7.2, 7.3) et est conçu de telle sorte qu'il empêche, en cas de dépassement des valeurs prédéfinies, l'accès à une zone de danger due à un danger électrique potentiel, par une commande correspondante de l'au moins un appareil périphérique (7.1, 7.2, 7.3) et, dans le cas où les valeurs prédéfinies ne sont pas atteintes, il autorise l'accès à la zone de danger due au danger électrique potentiel par une commande correspondante des appareils périphériques (7.1, 7.2, 7.3).

3. Agencement selon la revendication 2, **caractérisé en ce que** l'appareil de levage (3) présente une pluralité de mandrins de mesure (M1, M2, Mn) qui, lors du processus de levage, arrivent automatiquement en liaison électrique avec l'au moins une partie de boîtier (1.1) conductrice, **et en ce que** la pluralité de mandrins de mesure (M1, M2, Mn) sert à déterminer des différences de potentiel à l'aide d'une pluralité de processus de mesure indépendants.

4. Agencement selon l'une des revendications 2 ou 3,
**caractérisé en ce que**
- l'appareil de commande (30) est conçu de telle sorte qu'il déclenche un processus de mesure de vérification pour la vérification de l'appareil de mesure (31) avant et/ou après le processus de mesure proprement dit,
- l'appareil d'évaluation (32) est conçu de telle sorte que le résultat pour l'appareil de mesure (31) fonctionnant correctement est enregistré dans celui-ci sous la forme d'une plage de valeurs autorisée et l'appareil d'évaluation (32) compare le résultat de mesure avec la plage de valeurs autorisée,
- l'appareil de commande (30) est conçu de telle sorte que, en cas de non-concordance de la valeur mesurée avec une valeur de la plage de valeurs, il bloque un accès à la zone de danger due au danger électrique potentiel par une commande correspondante de l'appareil périphérique (7.1, 7.2, 7.3) et rejette la mesure pour la détermination d'une différence de potentiel ou ne l'effectue pas.

5. Agencement selon l'une des revendications 2 à 4, **caractérisé en ce que** le mandrin de mesure (M1, M2, Mn) présente une pointe de mesure (22) sollicitée par ressort contre le point de mesure (33), **et/ou en ce que** la pointe de mesure (22) est guidée dans un guide linéaire, dans lequel le guidage linéaire est maintenu dans un boîtier (13) et la pointe de mesure (22) est isolée électriquement de la face extérieure du boîtier par interposition d'une isolation, fait saillie hors du boîtier (13) par sa pointe et est reliée, à son extrémité opposée à la pointe, à une ligne de mesure (29) qui est elle-même sortie du boîtier (13).

6. Agencement selon la revendication 5, **caractérisé en ce que** la pointe de mesure (22) est précontrainte par rapport au boîtier (13) à l'aide d'un ressort en direction de sa pointe faisant saillie hors du boîtier (13) et le boîtier (13) présente un premier appui contre lequel la pointe de mesure (22) soumise à l'action d'un ressort s'appuie à l'état de repos à l'aide d'un second appui disposé sur elle.

7. Agencement selon l'une des revendications précédentes,
**caractérisé en ce que** l'au moins un appareil périphérique (7.1, 7.2, 7.3) est un appareil pour la signalisation acoustique et/ou la signalisation optique et/ou pour la libération ou le blocage d'une fermeture mécanique.

8. Procédé pour la détection automatisée d'un danger électrique avant l'exécution de travaux de montage sur une batterie haute tension à l'aide d'un agencement selon l'une des revendications précédentes, **caractérisé en ce**
**qu'à** l'aide de l'appareil de mesure (31), une différence de potentiel est déterminée entre la partie de boîtier de batterie (1.1) et un potentiel (P1W, P2W, PnW) qu'un ouvrier (W) reçoit pendant les travaux de montage.

9. Procédé selon la revendication 8, **caractérisé en ce que**
- le système de commande (4) formant l'appareil de commande (30) provoque un processus de mesure lors du levage de la batterie haute tension (1) hors du dispositif (2), de telle sorte que l'appareil de mesure (31) détermine une différence de potentiel ou une valeur de mesure corrélée entre la pointe de mesure (22) appliquée de manière électriquement conductrice sur la partie de boîtier de batterie (1.1) et le potentiel (P1W, P2W, PnW) qu'un ouvrier (W) reçoit pendant les travaux de montage,
- l'appareil de commande (30) compare, à l'aide de l'appareil d'évaluation (32), une différence de potentiel constatée ou une valeur de mesure corrélée avec des valeurs mémorisées prédéfinies et, en cas de dépassement des valeurs prédéfinies, bloque l'accès à la zone de danger due au danger électrique par une commande d'un appareil périphérique (7.1, 7.2, 7.3) pour la signalisation acoustique et/ou pour la signalisation optique et/ou pour la fermeture mécanique, et, dans le cas où les valeurs prédéfinies ne sont pas atteintes, autorise l'accès à la zone de danger due au danger électrique par commande d'un appareil périphérique (7.1, 7.2, 7.3) pour la signalisation acoustique et/ou pour la signalisation optique et/ou pour la fermeture mécanique.

10. Procédé selon la revendication 9, **caractérisé en ce que**
- l'appareil de commande (30) déclenche, pour la vérification de l'appareil de mesure (31), avant et/ou après le processus de mesure proprement dit, un processus de mesure de vérification dont le résultat est connu à l'avance pour l'appareil de mesure (31) fonctionnant correctement,
- l'appareil de commande (30) compare le résultat de mesure, à l'aide de l'appareil d'évaluation (32), à une valeur ou à une plage de valeurs prédéfinie et mémorisée,
- l'appareil de commande (30), en cas de non-dépassement, bloque un accès à la zone de danger due au danger électrique potentiel par commande d'un appareil périphérique (7.1, 7.2, 7.3) pour la signalisation optique et/ou pour la signalisation acoustique et/ou pour la fermeture mécanique et rejette ou n'effectue pas la mesure pour la détermination d'une différence de potentiel.
